Europäisches Patentamt

European Patent Office

Office européen des brevets

(11) Veröffentlichungsnummer : **0 364 679 B1**

## (12) EUROPÄISCHE PATENTSCHRIFT

(45) Veröffentlichungstag der Patentschrift :
02.11.94 Patentblatt 94/44

(51) Int. Cl.$^5$ : **H03L 7/16**

(21) Anmeldenummer : **89114052.7**

(22) Anmeldetag : **29.07.89**

(54) **Frequenzsynthesegerät.**

(30) Priorität : **18.10.88 CH 3876/88**

(43) Veröffentlichungstag der Anmeldung :
**25.04.90 Patentblatt 90/17**

(45) Bekanntmachung des Hinweises auf die
Patenterteilung :
**02.11.94 Patentblatt 94/44**

(84) Benannte Vertragsstaaten :
**CH DE FR GB IT LI NL SE**

(56) Entgegenhaltungen :
**EP-A- 0 147 897**
**DE-B- 1 177 697**
**FR-E- 92 133**
**GB-A- 2 015 277**

(56) Entgegenhaltungen :
**THE RADIO & ELECTRONIC ENGINEER, Band
50, Nr. 3, März 1980, Seiten 122-126, Institution
of Electronic and Radio Engineers, London,
GB; G.A. WARWICK et al: "The frequency
shifting synthesizer"**
**PATENT ABSTRACTS OF JAPAN, Band 9, Nr.
185 (E-332)[1908], 31. Juli 1985 & JP-A-60 55
730**

(73) Patentinhaber : **SIEMENS-ALBIS
AKTIENGESELLSCHAFT
PV/Patente und Verträge
Postfach
CH-8047 Zürich (CH)**

(72) Erfinder : **Fognini, Bruno
Am Suteracher 3
CH-8048 Zürich (CH)**
Erfinder : **Heinz, Helmut
Leonhard-Bugl-Strasse 6
D-8000 München 50 (DE)**

EP 0 364 679 B1

## Beschreibung

Die vorliegende Erfindung betrifft ein Frequenzsynthesegerät nach dem Oberbegriff des Patentanspruches 1.

Zur Frequenzsynthese in Frequenzsynthesegeräten werden oft phasengesteuerte Regelkreise (PLL's) verwendet. Im Buch "Theorie und Anwendungen des Phase-locked Loops" von Roland Best, (Aarau 1976) wird die prinzipielle Wirkungsweise dieser Schaltungen erläutert. Bild 79e auf Seite 82 zeigt dabei einen phasengesteuerten Regelkreis mit einem variablen Frequenzteiler und einer Mischstufe, der zur Erzeugung hoher Frequenzen geeignet ist. Dem phasengesteuerten Regelkreis werden eine variable oder fixe Offsetfrequenz und eine fixe Referenzfrequenz zugeführt. Das Phasenrauschen einer solchen Anordnung ist dabei vom Teilungsverhältnis des variablen Frequenzteilers abhängig und nimmt beim Teilungsverhältnis eins einen minimalen Wert an. Eine aus dem Hewlett-Packard Journal (Februar 1981) bekannte Verbesserung dieser Schaltung besteht darin, das Teilungsverhältnis des Frequenzteilers konstant gleich eins zu halten und dem phasengesteuerten Regelkreis zwei variable Frequenzen zuzuführen.

Soll das Ausgangssignal des phasengesteuerten Regelkreises frei von störenden Nebenwellen sein, so dürfen die zugeführten Offset- und Referenzfrequenzen ebenfalls keine Nebenwellen aufweisen. Zur Eliminierung der störenden Nebenwellen werden die Offset- und Referenzfrequenz je einem Bandpassfilter zugeführt. Wegen der erforderlichen Filtereinrichtungen ist diese Lösung jedoch mit einem hohen Aufwand verbunden.

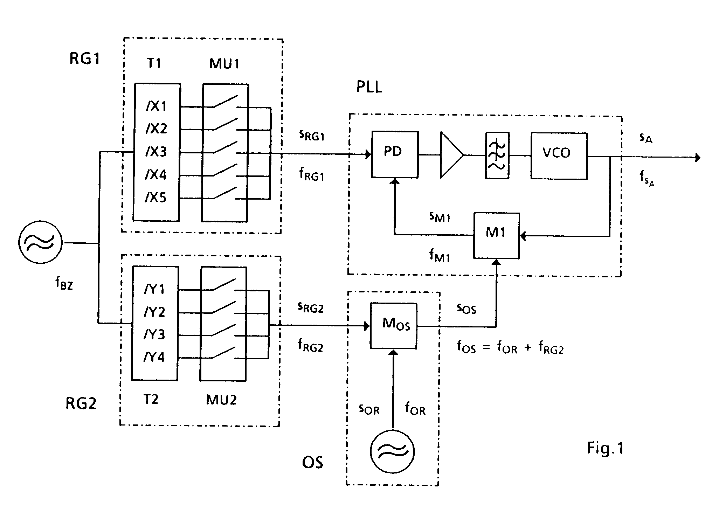

So ist z.B. aus "THE RADIO & ELECTRONIC ENGINEER, Band 50, Nr. 3, März 1980, Seiten 122 - 126, Institution of Electronic and Radio Engineers, London, GB; G. A. Warwick: "The frequency shifting syn-thesizer" ein Frequenzsynthesegerät (s. Figur 1) bekannt, das in der Lage ist, eine grosse Anzahl von Frequenzen zu erzeugen, die auf einem engen Frequenzraster liegen. Durch die Mischung von Frequenzen fo (Frequenz des Ausgangssignals), f1, f2 und f3 in einem Phasenregelkreis entstehen in diesem Frequenzsynthesegerät störende Oberwellen, die sich in weiteren Mischstufen u.U. gegenseitig wiederum überlagern. Dabei entstehen Mischprodukte von grösserer oder kleinerer Intensität, die nahe bei der Frequenz fo des Ausgangssignals liegen und die vom Phasenregelkreis (Tracking-Filter) daher nicht unterdrückt werden können. Zur Beseitigung dieser störenden Mischprodukte werden in diesem oder auch weiteren bekannten Frequenzsynthesegeräten (s. z.B.: DE-B-1 177 697, "Verfahren zur Gewinnung einer Frequenz ...") daher Filterstufen vorgesehen, die mit den oben angegebenen Nachteilen behaftet sind.

Der Erfindung liegt daher die Aufgabe zugrunde, die bekannte Schaltung zu verbessern. Diese Aufgabe wird durch die im Patentanspruch 1 angegebenen Massnahmen gelöst. Vorteilhafte Ausgestaltungen der Erfindung sind in weiteren Ansprüchen angegeben.

Vorteile des erfindungsgemässen Frequenzsynthesegerätes sind der reduzierte Schaltungsaufbau mit gleichzeitig erhöhter spektraler Reinheit der Ausgangssignale; die erwähnten Bandpassfilter entfallen, das Phasenrauschen wird reduziert und das Frequenzspektrum des Ausgangssignals ist frei von störenden Nebenwellen.

Die Erfindung wird nachfolgend anhand einer Zeichnung beispielsweise näher erläutert. Das dort gezeigte Frequenzsynthesegerät enthält einen phasengesteuerten Regelkreis PLL, bestehend aus einem Phasendetektor PD, einem Verstärkerbaustein, einem Tiefpassfilter, einer Mischstufe M1 und einem spannungsgesteuerten Oszillator VCO, dem zwei Signale $s_{OS}$ und $s_{RG1}$ mit den Frequenzen $f_{OS}$ bzw. $f_{RG1}$ zugeführt werden.

Die Frequenz $f_{RG1}$ entsteht im ersten Referenzfrequenzgenerator RG1 durch Teilung aus einer Bezugsfrequenz $f_{BZ}$ und nimmt wahlweise einen von fünf Werten an. Der Wert der Frequenz $f_{RG1}$ wird über einen Multiplexer MU1 angewählt. Die Frequenzteilung erfolgt in einem Teiler T1 mit den Teilungsfaktoren X1 ...X5. Zusätzlich zur Grundfrequenz $f_{RG1}$ können im Signal $s_{RG1}$ auch harmonische Schwingungen auftreten. Das Signal $s_{RG1}$ wird ohne vorherige Filterung einem Eingang des Phasendetektors PD des phasengesteuerten Regelkreises PLL zugeführt.

In gleicher Weise entsteht die Frequenz $f_{RG2}$ (mit den Teilungsfaktoren Y1...Y4), deren Wert über einen Multiplexer (MU2) angewählt wird. Das Signal $s_{RG2}$, welches nebst der Grundfrequenz $f_{RG2}$ ebenfalls harmonische Schwingungen enthält, wird einer Einseitenband - Mischstufe $M_{OS}$ in einer Offsetstufe OS zugeführt, an deren zweitem Eingang ein Signal $s_{OR}$ mit der Offsetreferenzfrequenz $f_{OR}$ liegt. Am Ausgang der Offsetstufe OS liegt das Signal $s_{OS}$ mit der Frequenz $f_{OS} = f_{OR} + f_{RG2}$ an. Der Offsetreferenzfrequenz $f_{OR}$ sind dabei auch die im Signal $s_{RG2}$ enthaltenen harmonischen Schwingungen überlagert. Das Signal $s_{OS}$ wird ungefiltert einem Eingang der Mischstufe M1 im phasengesteuerten Regelkreis PLL zugeführt.

Die Frequenz $f_{S_A} = f_{OR} + f_{RG2} + f_{RG1}$ des Ausgangssignals $s_A$ des spannungsgesteuerten Oszillators VCO und damit des Frequenzsynthesegerätes wird gebildet, indem die in der Mischstufe M1 erzeugte Frequenzdifferenz $f_{M1} = f_{S_A} - (f_{OR} + f_{RG2})$ im Phasendetektor PD mit der Frequenz $f_{RG1}$ verglichen wird. Im einge-

2

schwungenen Zustand des Regelkreises nehmen die Frequenzen $f_{RG1}$ und $f_{M1}$ den gleichen Wert an.

Durch Mischung der ungefilterten Signale $s_{OS}$ und $s_{RG1}$ im phasengesteuerten Regelkreis PLL resultieren Frequenzen $f_{res}$, die der allgemeinen Gleichung

$$f_{res}(l,m,n) = l\, f_{OR} + m\, f_{RG2} + n\, f_{RG1} \quad (1)$$

entsprechen ($l,m,n$ sind positive oder negative ganze Zahlen). Die Frequenz $f_{S_A}$ entspricht dabei dem Spezialfall mit $l,m,n = +1$ d.h. $f_{S_A} = f_{OR} + f_{RG2} + f_{RG1}$.

Da die Frequenz $f_{OR}$ normalerweise in der gleichen Grössenordnung ist wie die Frequenz $f_{S_A}$, werden ganzzahlige Vielfache von $f_{OR}$ für die weiteren Betrachtungen vernachlässigt, d.h. der Koeffizient $l$ in Formel (1) wird gleich $+1$ gesetzt.

Zusätzlich zur gewünschten Frequenz $f_{S_A}$ treten im phasengesteuerten Regelkreis PLL störende Frequenzen auf, die aus folgender Formel hergeleitet werden können:

$$f_{res}(m,n) = f_{OR} + m\, f_{RG2} + n\, f_{RG1} \quad (m,n \neq +1) \quad (2)$$

Diese Störfrequenzen werden erfindungsgemäss durch zwei Massnahmen eliminiert : Zunächst wird der phasengesteuerte Regelkreis als Tracking-Filter ausgebildet. Er wirkt somit als verschiebbarer Bandpass mit steilen Flanken und kleiner Bandbreite $B_{TF}$, welche durch die Loopbandbreite des phasengesteuerten Regelkreises PLL gegeben ist. Frequenzen $f_{res}$, die ausserhalb der Bandbreite $B_{TF}$ des Tracking-Filters liegen, werden folglich gesperrt. Der Aufbau und die Funktionsweise eines solchen Tracking-Filters sind im eingangs erwähnten Buch, Seite 55 näher erläutert.

Die zweite Massnahme zur Eliminierung der Störfrequenzen besteht darin, die Referenzfrequenzen $f_{RG1}$ und $f_{RG2}$ derart zu wählen, dass alle resultierenden Frequenzen $f_{res}$ ohne $f_{S_A}$ (d.h. in Formel (2) $f_{res}$ mit $m,n \neq +1$) gemäss der Bedingung

$$\left| f_{res} - f_{S_A} \right| > \tfrac{1}{2}\, B_{TF} \quad (3)$$

ausserhalb der Bandbreite $B_{TF}$ des Tracking-Filters liegen. Falls höhere Dämpfungswerte für die Störfrequenzen verlangt werden, kann der resultierende Wert für $1/2\, B_{TF}$ mit einem zusätzlichen Faktor ($>1$) multipliziert werden; d.h. störende Nebenwellen liegen weiter ausserhalb der Bandbreite $B_{TF}$ des Tracking - Filters und werden stärker gedämpft bzw. ganz unterdrückt.

Durch die Referenzfrequenzgeneratoren RG1 und RG2 werden nicht nur die angewählten Referenzfrequenzen $f_{RG1}$ und $f_{RG2}$ erzeugt, sondern auch deren Vielfache. Das resultierende Frequenzraster mit dem engsten Linien- bzw. Nebenwellenabstand wird vom Referenzfrequenzgenerator RG1 bei der Erzeugung der tiefsten Frequenz $f_{RG1min}$ abgegeben. Der minimale Linienabstand dieses Frequenzrasters, welches dem Tracking - Filter zugeführt wird, entspricht demnach dem Wert der Frequenz $f_{RG1min}$. Durch geschickte Wahl der weiteren Frequenzen $f_{RG1}$ und $f_{RG2}$ wird nun erreicht, dass zusätzliche im phasengesteuerten Regelkreis auftretende Frequenzraster, welche über die Offsetstufe OS und die Mischstufe M1 dem Tracking - Filter zugeführt werden, mit dem oben erwähnten Frequenzraster deckungsgleich sind (soweit keine Frequenzlücken im Raster vorhanden sind) und folglich auch den gleichen Linienabstand haben. Gemäss Formel (2) treten im phasengesteuerten Regelkreis PLL Frequenzen $f_{res} = f_{OR} + m\, f_{RG2} + n\, f_{RG1}$ auf, die im phasengesteuerten Regelkreis PLL ein Frequenzraster bilden. In Formel (2) sind auch alle Mischprodukte enthalten, die durch Mischung aus den verschiedenen Frequenzrastern entstehen. Vielfache der Offsetreferenzfrequenz $f_{OR}$ werden vernachlässigt, da sie zusammen mit den sich dazu ergebenden Frequenzrastern weit ausserhalb der Bandbreite $B_{TF}$ des Tracking - Filters liegen. Das durch die Frequenzen $f_{res}$ gebildete Frequenzraster wird dem Tracking - Filter zugeführt, welches die Ausgangsfrequenz $f_{S_A} = f_{OR} + f_{RG2} + f_{RG1}$ passieren lässt und die Nebenwellen gemäss Formel (3) sperrt. Die Nebenwellen werden jedoch nur gesperrt, wenn der geforderte Linienabstand nie unterschritten wird. Indem alle Referenzfrequenzen $f_{RG1}$ und $f_{RG2}$ als ganzzahliges Vielfaches der Frequenz $f_{RG1min}$ gewählt werden, ergibt sich für das Frequenzraster von $f_{res}$ ein minimaler Linienabstand, der der Frequenz $f_{RG1min}$ entspricht. Der kleinstmögliche Linienabstand der Ausgangsfrequenz $f_{S_A}$ von den nächsten Nebenlinien bzw. Nebenwellen entspricht folglich dem Wert der Frequenz $f_{RG1min}$. Die entstehenden Nebenwellen werden deshalb vom Tracking - Filter unterdrückt.

Die Referenzfrequenzen $f_{RG1}$ und $f_{RG2}$ werden nun nach folgenden Kriterien gewählt :

1.) Alle Referenzfrequenzen $f_{RG1}$ und $f_{RG2}$ müssen einem Vielfachen der Frequenz $f_{RG1min}$ entsprechen. Vorzugsweise werden die Frequenzen $f_{RG2}$ als Vielfaches der höchsten Frequenz von $f_{RG1}$ gewählt.

2.) Der Wert der Frequenz $f_{RG1min}$ muss grösser sein als die halbe Bandbreite des Tracking -Filters ( $f_{RG1min} > \tfrac{1}{2}\, B_{TF}$ ). Um höhere Dämpfungswerte für die Nebenwellen zu erreichen, kann die Frequenz $f_{RG1min}$ entsprechend erhöht werden.

Vorzugsweise sind die Frequenzen $f_{RG1}$ entsprechend der folgenden Formel (4) zu wählen :

$$f_{RG1} = q \times f_{RG1min} \quad (q = 1,2,3,\ldots,p) \quad (4)$$

Der Maximalwert der Frequenz $f_{RG1}$ ist demnach $f_{RG1max} = p \times f_{RG1min}$. Für die Frequenzen $f_{RG2}$ gilt vorzugs-

3

weise:

$$f_{RG2} = r \times f_{RG1max} \ (r = 1,2,3,...,s) \quad (5)$$

Der Maximalwert der Frequenz $f_{RG2}$ ist folglich $f_{RG2max} = s \times f_{RG1max}$. Mit diesen Bedingungen für die Frequenzen $f_{RG1}$ bzw. $f_{RG2}$ erhält das Ausgangssignal $s_A$ die folgenden Eigenschaften:

- Die Abstände zwischen benachbarten Frequenzkanälen sind immer gleich.
- Die maximal mögliche Anzahl Kanäle in diesem Beispiel ist $K_{max} = s \times p$.

In einem der näheren Erläuterung dienenden nachstehenden Zahlenbeispiel wurden die Frequenzen $f_{RG1}$ und $f_{RG2}$ gemäss den Formeln (4) und (5) wie folgt gewählt:

| $f_{BZ}$ (MHz) | $X_{(1...5)}$ | $f_{RG1}$ (MHz) | $Y_{(1..4)}$ | $f_{RG2}$ (MHz) |
|---|---|---|---|---|
| 135 | 60 | 2,25 | 12 | 11,25 |
| | 30 | 4,50 | 6 | 22,50 |
| | 20 | 6,75 | 4 | 33,75 |
| | 15 | 9,00 | 3 | 45,00 |
| | 12 | 11,25 | | |

Das Einsetzen obiger Werte in Formel (2) ergibt Frequenzen, die der Frequenz $f_{S_A}$ entsprechen oder immer um Vielfache von 2,25 MHz davon abweichen. Durch die Wirkung des Tracking - Filters gelangt folglich nur die Frequenz $f_{S_A}$ zum Ausgang des phasengesteuerten Regelkreises PLL.

Die Anzahl Frequenzkanäle kann erhöht werden, indem dem Ausgang der Offsetstufe OS, z.B. über einen Multiplexer, nebst der Frequenz $(f_{or} + f_{RG2})$ auch die Offsetreferenzfrequenz $f_{OR}$ und das Mischprodukt $(f_{or} - f_{RG2})$ zugeführt werden kann. Die resultierende maximale Anzahl Frequenzkanäle entspricht dann der Formel $K_{max} = p \times (2s + 1)$.

Die Offsetreferenzfrequenz $f_{OR}$, welche frei von störenden Nebenwellen sein muss, kann durch Multiplikation oder Teilung aus der Bezugsfrequenz $f_{BZ}$ hervorgehen $(f_{OR} = k \times f_{BZ})$ oder durch Auswahl aus 1 bis n Sinusgeneratoren (mit der Frequenz $f_{OR_1}, ... , f_{OR_n}$; n kann beliebig gewählt werden) oder durch ein Frequenzsynthesegerät mit variabler Ausgangsfrequenz erzeugt werden. Entstehende Nebenwellen (z.B. harmonische Schwingungen), deren Frequenzen einem Mehrfachen der Offsetreferenzfrequenz $f_{OR}$ entsprechen, sind zulässig, da sie im phasengesteuerten Regelkreis weit ausserhalb der Bandbreite $B_{TF}$ des Trackings - Filters liegen und gesperrt werden. Durch eine gerasterte oder variable Änderung der Offsetreferenzfrequenz $f_{OR}$ kann die Anzahl Frequenzkanäle $K_{max}$ beliebig erhöht oder ein ganzes Frequenzband abgedeckt werden.

Für eine zusätzliche Erhöhung der Ausgangsfrequenz $f_{S_A}$ des erfindungsgemässen Frequenzsynthesegerätes kann das Signal $s_A$ einer Frequenzmultiplikationsstufe zugeführt werden, welche die Frequenz $f_{S_A}$ mit einem gewünschten Faktor multipliziert und dem Ausgang des Frequenzsynthesegerätes zuführt.

Die minimale Zeitdauer, die das beschriebene Frequenzsynthesegerät für einen Frequenzwechsel benötigt, entspricht etwa der Einschwingzeit des phasengesteuerten Regelkreises auf eine neue Frequenz. Kürzere Umschaltzeiten werden ermöglicht, indem die Ausgänge von zwei oder mehreren erfindungsgemässen Frequenzsynthesegeräten, die identische oder verschiedene Frequenzkanäle abdecken, über einen Multiplexer zusammengeschaltet werden. Der Ausgang des Frequenzsynthesegerätes, welches die momentane Ausgangsfrequenz $f_{S_A}$ erzeugt, wird vom Multiplexer angewählt. In den weiteren Frequenzsynthesegeräten werden zukünftig benötigte Frequenzen eingestellt und bereitgehalten, so dass sie vom Multiplexer sofort angewählt werden können.

Falls zeitweise ein schneller Frequenzwechsel gewünscht ist und die Anforderungen an die Qualität der Ausgangssignale $s_A$ reduziert sind (erhöhtes Phasenrauschen), so kann der Eingang des spannungsgesteuerten Oszillators VCO direkt über einen Digital-Analog-Wandler angesteuert werden, über den die gewünschte Frequenz $f_{S_A}$ digital angewählt wird.

Frequenzen, die nicht den einstellbaren Frequenzkanälen entsprechen, können mit reduzierter Qualität (Nebenwellen und erhöhtes Phasenrauschen) erzeugt werden, indem das Signal $s_{M1}$ einem Frequenzteiler zugeführt wird, der im Normalbetrieb ein Teilungsverhältnis eins und zur Erzeugung der gewünschten zusätzlichen Frequenzen ein entsprechendes Teilungsverhältnis ungleich eins hat.

**Patentansprüche**

1. Frequenzsynthesegerät zum Erzeugen von verschiedenen Frequenzkanälen, mit zwei Referenzfrequenzgeneratoren (RG1, RG2), einer Offsetstufe (OS) und einem phasengesteuerten Regelkreis(PLL), **dadurch gekennzeichnet,**
dass die Referenzfrequenzgeneratoren (RG1) und (RG2) Signale $s_{RG1}$ und $s_{RG2}$ erzeugen, deren Frequenzen $f_{RG1}$ bzw. $f_{RG2}$ gleich einem Bruchteil einer Bezugsfrequenz $f_{BZ}$ wählbar sind,
dass die Frequenz $f_{OS}$ des Ausgangssignals $s_{OS}$ der Offsetstufe (OS) den Wert einer vorbestimmten Frequenz $f_{OR}$ eines Offsetreferenzsignals $s_{OR}$ oder den Wert einer Frequenz ($f_{OR} + f_{RG2}$ bzw. $f_{OR} - f_{RG2}$) eines durch Verknüpfung der Signale $s_{OR}$ und $s_{RG2}$ gebildeten Summen- bzw. Differenzsignals annimmt,
dass am Ausgang des spannungsgesteuerten Oszillators (VCO) im phasengesteuerten Regelkreis (PLL) das Ausgangssignal $s_A$ des Frequenzsynthesegerätes erzeugt wird, dessen Frequenz $f_{S_A}$ durch Addition der Frequenzen $f_{RG1}$ und $f_{OS}$ der Signale $s_{RG1}$ bzw. ($s_{OS}$) gebildet wird,
dass der phasengesteuerte Regelkreis (PLL) als Trackingfilter ausgebildet ist, und
dass alle Frequenzen der Referenzfrequenzgeneratoren (RG1, RG2) und der Offsetstufe (OS) derart gewählt bzw. miteinander kombiniert sind, dass entstehende Seitenbänder immer ausserhalb der Bandbreite des Trackingfilters liegen.

2. Frequenzsynthesegerät nach Anspruch 1, **dadurch gekennzeichnet**, dass alle von den Referenzfrequenzgeneratoren (RG1) und (RG2) abgegebenen Frequenzen $f_{RG1}$ bzw. $f_{RG2}$ einem Vielfachen der tiefsten vom Referenzfrequenzgenerator (RG1) erzeugten Frequenz $f_{RG1min}$ entsprechen und dass der Wert der Frequenz $f_{RG1min}$ grösser ist als die halbe Bandbreite des Tracking- Filters ($f_{RG1min} > \frac{1}{2}B_{TF}$).

3. Frequenzsynthesegerät nach Anspruch 2, **dadurch gekennzeichnet**, dass alle Frequenzen $f_{RG2}$ einem Vielfachen der höchsten vom Referenzfrequenzgenerator (RG1) erzeugten Frequenz $f_{RG1max}$ entsprechen.

4. Frequenzsynthesegerät nach einem der vorstehenden Ansprüche, **dadurch gekennzeichnet**, dass die Signale $s_A$ und $s_{OS}$ einer Mischstufe (M1) im phasengesteuerten Regelkreis (PLL) zugeführt werden, an deren Ausgang ein Signal $s_{M1}$ mit der Frequenz ($f_{S_A} - f_{OS}$) gebildet wird, dessen Phase im Phasendetektor (PD) des Regelkreises (PLL) mit der Phase des Signals $s_{RG1}$ verglichen wird.

5. Frequenzsynthesegerät nach Anspruch 4, **dadurch gekennzeichnet**, dass die Offsetreferenzfrequenz $f_{OR}$ der Bedingung $f_{OR} = k \times f_{BZ}$ ($k < 1$ oder $k > 1$) genügt oder dass die Offsetreferenzfrequenz $f_{OR}$ wahlweise von einem von mehreren Sinusgeneratoren mit stabiler Frequenz erzeugt wird oder dass die Offsetreferenzfrequenz $f_{OR}$ wenigstens annähernd entsprechend dem halben Kanalabstand der Ausgangsfrequenzen $f_{S_A}$ variabel ist.

6. Frequenzsynthesegerät nach einem der vorstehenden Ansprüche, **dadurch gekennzeichnet**, dass das Signal $s_A$ einem Frequenzvervielfacher zuführbar ist.

7. Frequenzsynthesegerät nach einem der vorstehenden Ansprüche, **dadurch gekennzeichnet**, dass es mit weiteren gleichartigen Frequenzsynthesegeräten derart zusammengeschaltet ist, dass die Signale $s_A$ der einzelnen Geräte über einen Schalter oder Multiplexer an einen Verbraucher anschaltbar sind und die Geräte dabei identische oder wenigstens zum Teil unterschiedliche Frequenzkanäle abdecken.

8. Frequenzsynthesegerät nach einem der vorstehenden Ansprüche, **dadurch gekennzeichnet**, dass der Eingang des spannungsgesteuerten Oszillators (VCO) auf den Ausgang eines Digital-Analog Wandlers umschaltbar ist, über den die Frequenz $f_{S_A}$ digital einstellbar ist.

9. Frequenzsynthesegerät nach einem der vorstehenden Ansprüche, **dadurch gekennzeichnet**, dass das Ausgangssignal $s_{M1}$ der Mischstufe (M1) über einen Frequenzteiler dem Eingang des Phasendetektors (PD) zugeführt wird.

**Claims**

1. Frequency synthesis device for generating various frequency channels, having two reference frequency generators (RG1, RG2), an offset stage (OS) and a phase-locked loop (PLL), characterised in that
- the reference frequency generators (RG1) and (RG2) generate signals $s_{RG1}$ and $s_{RG2}$ whose frequencies $f_{RG1}$ and $f_{RG2}$ can be selected to be equal to a fraction of a reference frequency $f_{BZ}$,
- the frequency $f_{OS}$ of the output signal $S_{OS}$ of the offset stage (OS) assumes the value of a predetermined frequency $f_{OR}$ of an offset reference signal $s_{OR}$ or the value of a frequency ($f_{OR} + f_{RG2}$ or $f_{OR} - f_{RG2}$) of a summation- or differential signal formed by connection of the signals $s_{OR}$ and $s_{RG2}$,
- at the output of the voltage-controlled oscillator (VCO) in the phase-locked loop (PLL) the output signal $s_A$ of the frequency synthesis device is generated, the frequency $f_{SA}$ of which is formed by addition of the frequencies $f_{RG1}$ and $f_{OS}$ of the signals $s_{RG1}$ or $s_{OS}$,
- the phase-locked loop (PLL) is designed as a tracking filter, and
- all the frequencies of the reference frequency generators (RG1, RG2) and the offset stage (OS) are selected or are combined with each other in such a way that resultant side bands always lie outside the band width of the tracking filter.

2. Frequency synthesis device according to claim 1, characterised in that all the frequencies $f_{RG1}$ or $f_{RG2}$ emitted from the reference frequency generators (RG1) and (RG2) correspond to a multiple of the lowest frequency $f_{RG1min}$ generated by the frequency generator (RG1) and in that the value of the frequency $f_{RG1min}$ is greater than half the band width of the tracking filter ($f_{RG1min} > \frac{1}{2} B_{TF}$).

3. Frequency synthesis device according to claim 2, characterised in that all the frequencies $f_{RG2}$ correspond to a multiple of the highest frequency $f_{RG1max}$ generated by the reference frequency generator (RG1).

4. Frequency synthesis device according to one of the preceding claims, characterised in that the signals $s_A$ and $s_{OS}$ are conveyed to a mixing stage (M1) in the phase-locked loop (PLL) at the output of which a signal $s_{M1}$ with the frequency ($f_{SA} - f_{OS}$) is formed whose phase is compared with the phase of the signal $s_{RG1}$ in the phase detector (PD) of the phase-locked loop (PLL).

5. Frequency synthesis device according to claim 4, characterised in that the offset reference frequency $f_{OR}$ satisfies the condition $f_{OR} = k \times f_{BZ}$ ($k < 1$ or $k > 1$) or that the offset reference frequency $f_{OR}$ is generated optionally by one of several sinusoidal generators with stable frequency or that the offset reference frequency $f_{OR}$ is variable at least approximately corresponding to half the band spacing of the output frequencies $f_{SA}$.

6. Frequency synthesis device according to one of the preceding claims, characterised in that the signal $s_A$ can be conveyed to a frequency multiplier.

7. Frequency synthesis device according to one of the preceding claims, characterised in that it is connected together with other similar frequency synthesis devices in such a way that the signals $s_A$ of the individual devices can be connected by means of a switch or multiplexer to a consumer and the devices cover identical or at least partially different frequency bands.

8. Frequency synthesis device according to one of the preceding claims, characterised in that the input of the voltage-controlled oscillator (VCO) can be switched over to the output of a digital-analog converter by means of which the frequency $f_{SA}$ can be digitally adjusted.

9. Frequency synthesis device according to one of the preceding claims, characterised in that the output signal $s_{M1}$ of the mixing stage (M1) is conveyed by means of a frequency divider to the input of the phase detector (PD).

## Revendications

1. Synthétiseur de fréquences servant à produire différents canaux de fréquences, comportant deux canaux de fréquences de référence (RG1, RG2), un étage d'offset (OS) et un circuit de régulation à commande de phase (PLL), caractérisé par le fait
que les générateurs de fréquences de référence (RG1, RG2) produisent des signaux $s_{RG1}$ et $s_{RG2}$, dont les fréquences $f_{RG1}$ et $f_{RG2}$ peuvent être choisies égales à une fraction d'une fréquence de référence $f_{BZ}$,
que la fréquence $f_{OS}$ du signal de sortie $s_{OS}$ de l'étage d'offset (OS) prend la valeur d'une fréquence prédéterminée $f_{OR}$ d'un signal de référence d'offset $s_{OR}$ ou la valeur d'une fréquence $f_{OR}+f_{RG2}$ ou $f_{OR}-f_{RG2}$ d'un signal somme ou d'un signal de différence formé par combinaison des signaux $s_{OR}$ et $s_{RG2}$,

que le signal de sortie $s_A$ du synthétiseur de fréquence est produit à la sortie de l'oscillateur commandé par la tension (VCO) dans le circuit de régulation à commande de phase (PLL), signal de sortie dont la fréquence $f_{SA}$ est formée par addition des fréquences $f_{RG1}$ et $f_{OS}$ des signaux $s_{RG1}$ et $s_{OS}$, que le circuit de régulation à commande de phase (PLL) est réalisé sous la forme d'un filtre suiveur, et

que toutes les fréquences des générateurs de fréquences de référence (RG1, RG2) et de l'étage d'offset (OS) sont choisies ou combinées entre elles de telle sorte que des bandes latérales, qui apparaissent, sont toujours situées à l'extérieur de la largeur de bande du filtre suiveur.

2. Synthétiseur de fréquences suivant la revendication 1, caractérisé par le fait que toutes les fréquences $f_{RG1}$ ou $f_{RG2}$, qui sont délivrées par les générateurs de fréquences de référence (RG1, RG2), correspondent à un multiple de la fréquence la plus basse $f_{RG1min}$ produite par le générateur de fréquence de référence (RG1) et que la valeur de la fréquence $f_{RG1min}$ est supérieure à la moitié de la largeur de bande du filtre suiveur ($f_{RG1min} > \frac{1}{2} B_{TF}$).

3. Synthétiseur de fréquences suivant la revendication 2, caractérisé par le fait que toutes les fréquences $f_{RG2}$ correspondent à un multiple de la fréquence maximale $f_{RG1max}$, produite par le générateur de fréquence de référence (RG1).

4. Synthétiseur de fréquences suivant l'une des revendications précédentes, caractérisé par le fait que les signaux $s_A$ et $s_{OS}$ sont envoyés à un étage mélangeur (M1) situé dans le circuit de régulation à commande de phase (PLL), à la sortie duquel est formé un signal $s_{M1}$ possédant la fréquence $f_{SA}-f_{OS}$ et dont la phase est comparée, dans le détecteur de phase (PD) du circuit de régulation (PLL), à la phase du signal $s_{RG1}$.

5. Synthétiseur de fréquences suivant la revendication 4, caractérisé par le fait que la fréquence de référence d'offset $f_{OR}$ satisfait à la condition $f_{OR}=k \times f_{BZ}$ (k < ou k > 1) ou que la fréquence de référence d'offset $f_{OR}$ est produite au choix par l'un de plusieurs générateurs sinusoïdaux ayant une fréquence stable, ou que la fréquence de référence d'offset $f_{OR}$ est variable au moins approximativement en fonction de la moitié de la distance entre les canaux des fréquences de sortie $f_{SA}$.

6. Synthétiseur de fréquences suivant l'une des revendications précédentes, caractérisé par le fait que le signal $s_A$ peut être envoyé à un multiplicateur de fréquences.

7. Synthétiseur de fréquences suivant l'une des revendications précédentes, caractérisé par le fait qu'il est interconnecté à d'autres synthétiseurs identiques de fréquences de telle sorte que les signaux $s_A$ des différents appareils peuvent être appliqués, par l'intermédiaire d'un commutateur ou d'un multiplexeur, à un appareil d'utilisation, et que les appareils couvrent des canaux de fréquences identiques ou au moins partiellement différents.

8. Synthétiseur de fréquences suivant l'une des revendications précédentes, caractérisé par le fait que l'entrée de l'oscillateur commandé par la tension (VCO) peut être commutée sur la sortie d'un convertisseur numérique/ analogique, au moyen duquel la fréquence $f_{SA}$ est réglable numériquement.

9. Synthétiseur de fréquences suivant l'une des revendications précédentes, caractérisé par le fait que le signal de sortie $s_{M1}$ de l'étage mélangeur (M1) est envoyé, par l'intermédiaire d'un diviseur de fréquence, à l'entrée du détecteur de phase (PD).

Fig.1

EP 0 364 679 B1